# EUROPEAN PATENT SPECIFICATION

(11) **EP 3 485 521 B1**
(45) Date of publication and mention of the grant of the patent: **23.09.2020**
(21) Application number: 17796679.3
(22) Date of filing: 09.05.2017
(51) Int. Cl.: H01L 33/58, G02B 19/00, H01L 33/00

(54) **COLLIMATING ON-DIE OPTIC, LIGHT-EMITTING DIODE PACKAGE WITH THE SAME AND METHOD FOR MANUFACTURING THE SAME**
KOLLIMIERENDE ON-DIE-OPTIK, LEUCHTDIODE-GEHÄUSE MIT DER GLEICHEN UND HERSTELLUNGSVERFAHREN DAFÜR
OPTIQUE DE COLLIMATION SUR PUCE, BOÎTIER DE DIODE ÉLECTROLUMINESCENTE L'INCORPORANT ET SON PROCÉDÉ DE FABRICATION

(30) Priority: 12.05.2016 US 201662335334 P; 05.07.2016 EP 16178038
(43) Date of publication of application: 22.05.2019
(73) Proprietor: Lumileds Holding B.V., 1118 CL Schiphol (NL); Bloemen, Pascal, San Jose, California 95131 (US); Van-Lierop, Maarten, San Jose, California 95131 (US); Nijkamp, Rick, San Jose, California 95131 (US); Steltenpool, Mark, San Jose, California 95131 (US); Cornelissen, Hugo, San Jose, California 95131 (US)
(72) Inventor: BLOEMEN, Pascal, 52068 Aachen (DE); VAN-LIEROP, Maarten, 52068 Aachen (DE); NIJKAMP, Rick, 52068 Aachen (DE); STELTENPOOL, Mark, 52068 Aachen (DE); CORNELISSEN, Hugo, 52068 Aachen (DE)
(74) Representative: ter Heegde, Paul Gerard Michel
(86) International application number: PCT/US2017/031724
(87) International publication number: WO 2017/196824

(56) References cited:
- EP-A1- 0 117 606
- WO-A1-2015/092014
- US-A1- 2006 018 010
- US-A1- 2007 041 210
- US-A1- 2008 285 275
- US-A1- 2010 059 776
- US-A1- 2010 226 127
- US-A1- 2015 070 900
- US-B2- 7 083 315
- US-B2- 7 697 219
- US-B2- 7 892 268
- US-B2- 9 223 080

## Description

### FIELD OF THE INVENTION

The present disclosure relates to semiconductor light-emitting diodes (LEDs), and more particular to on-die optics for LEDs.

### BACKGROUND

In light-emitting diode (LED) lighting applications, optic is designed around an LED die to achieve a certain degree of control to where the light is directed. The optics is often mounted separately from the LED die. To reduce this two-stage assembly, an overmold optic is designed to integrate the optic and the LED die. One example of overmold optics is the hemispherical dome molded over the die that increases the extraction efficiency of the LED die but does not redirect the light. Another example is the side-emitter overmold optic that both increases the extraction efficiency and redirects the light from the LED die to deform the radiation pattern from Lambertian to side emitting.

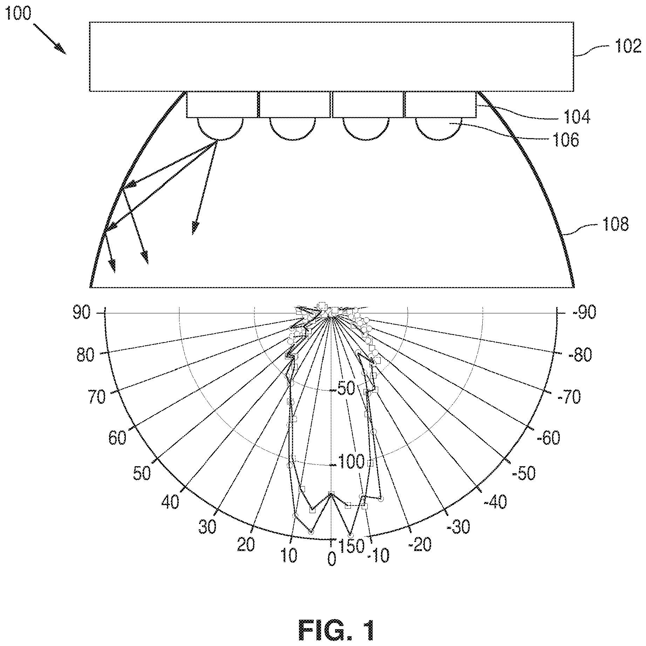

Fig. 1 illustrates a conventional LED package 100. Package 100 includes a heat sink 102, LED dies 104 (only one is labeled), primary optics 106 (only one is labeled) on LED dies 104, and a secondary optic 108 mounted on heat sink 102. LED die 104 may include an LED and a wavelength converter, such as a ceramic phosphor, on the LED. Primary optics 106 are hemispherical dome overmolds that help to extract light from LED dies 104 but does redirect the extracted light. Secondary optic 108 is a reflector that collimates the extracted light as shown in the intensity slice diagram on the figure. Note that 0 degrees corresponds to a direction perpendicular to the top surface of the LED die 104.

US 7 083 315 B2 discloses a runway and taxiway lighting system using LEDs and a light pipe. US 2006/018010 A1 discloses an optical element for uniform illumination. US 2010/226127 A1 discloses light-mixing optic for use with one or more light sources such as LEDs.

US 2008/285275 A1 discloses a lighting device in the form of a matrix illumination system with a plurality of LEDs connected to a collimating optical component. US 2015/070900 A1 discloses a spotlight comprising a wide angle light source and catadioptric lens. EP 0 117 606 A1 discloses a light collector for an LED array. WO 2015/092014 A1 discloses a method for printing a three-dimensional light guiding structure.

### SUMMARY

The optic of the invention is defined in claim 1. The light-emitting diode (LED) package of the invention is defined in claim 6. The method of the invention for making the light-emitting diode (LED) package is defined in claim 10. Further advantageous aspects of the invention are the object of the appended dependent claims.

One or more examples of the present disclosure provide an optic that is in optical contact with an LED die and substantially collimates light from the die. The optic is similar in size as the conventional hemispherical dome overmold. The optic includes a truncated compound parabolic concentrator (CPC) and a tilted wedge atop the truncated CPC.

The truncated CPC includes an input face and a lower exterior surface defined by a tilted parabolic segment rotated about an axis of symmetry. The bottom end of the lower exterior surface joins the perimeter of the input face.

The tilted wedge includes an upper exterior surface above the lower exterior surface, and an interior conical surface surrounded by the lower and the upper exterior surfaces. The upper exterior surface is defined by a tilted straight line rotated about the axis of symmetry. The interior conical surface is defined by a parametric curve rotated about the axis of symmetry. The interior conical surface has a vertex located at the axis of symmetry and within the lower exterior surface. The top ends of the interior conical surface and the upper exterior surface join to define an output aperture.

### BRIEF DESCRIPTION OF THE DRAWINGS

In the drawings:
Fig. 1 illustrates a conventional light-emitting diode (LED) package.
Fig. 2 illustrates a LED package in examples of the present disclosure.
Figs. 3-1 and 3-2 respectively illustrate a cross-sectional side view and an isometric view of an optic of Fig. 2 in examples of the present disclosure.
Fig. 4 illustrates ray tracing through the optic of Fig. 2 in examples of the present disclosure.
Fig. 5 illustrates that the optic of Fig. 2 has dimensions similar to a conventional hemispherical overmold in some examples of the present disclosure.
Fig. 6 illustrates the design of a full height compact parabolic concentrator (CPC) cut to form a truncated CPC that forms part of the optic of Fig. 2 in examples of the present disclosure.
Fig. 7 illustrates the design of a tilted wedge superimposed on the truncated CPC of the optic of Fig. 2 in examples of the present disclosure.
Figs. 8, 9, and 10 respectively illustrate the far field intensity distribution in intensity slices, the far field intensity distribution in cross-sections, and the forward intensity distribution of the optic of Fig. 2 in examples of the present disclosure.

Use of the same reference numbers in different figures indicates similar or identical elements.

### DETAILED DESCRIPTION

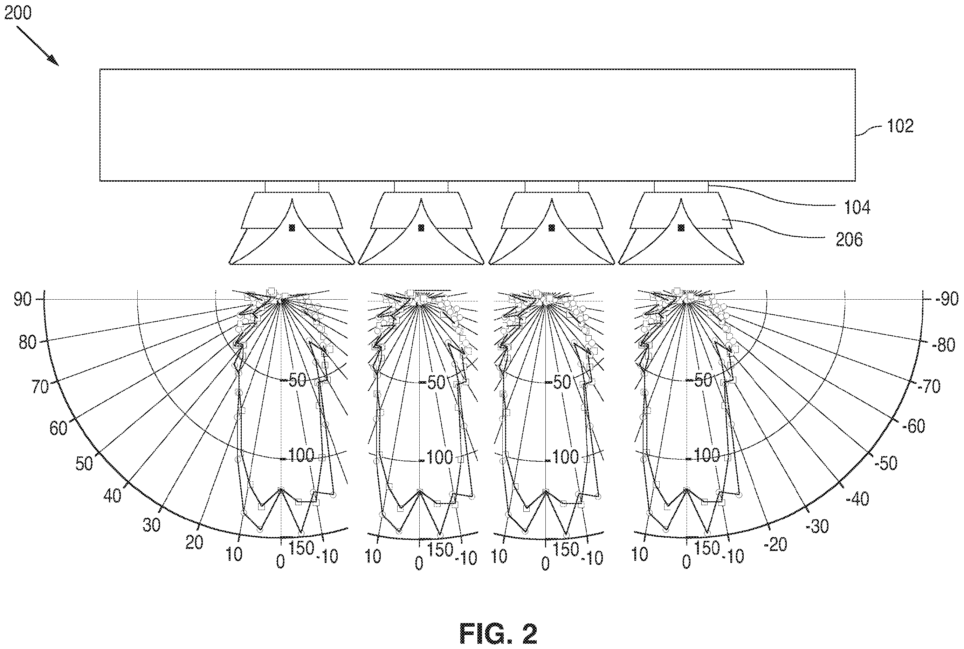

Fig. 2 illustrates a light-emitting diode (LED) package 200 in examples of the present disclosure. Package 200 includes heat sink 102, LED dies 104, and optics 206 (only one is labeled) on LED dies 104. Unlike primary optics 106, optics 206 collimates light from LED dies 104. Optics 206 may be printed onto LED dies 104. Alternatively, optics 206 are made individually or as an array, and optics 206 are attached to LED dies 104 individually or as an array.

The beam pattern of optic 206 deviates substantially from the circle pattern that is characteristic of a Lambertian-like emission. Optic 206 may be the sole optic in some applications or a primary optic that redirects light onto a secondary optic in other applications. In either case, light is used more efficiency so that the number of LED dies or the amount of electrical power is reduced.

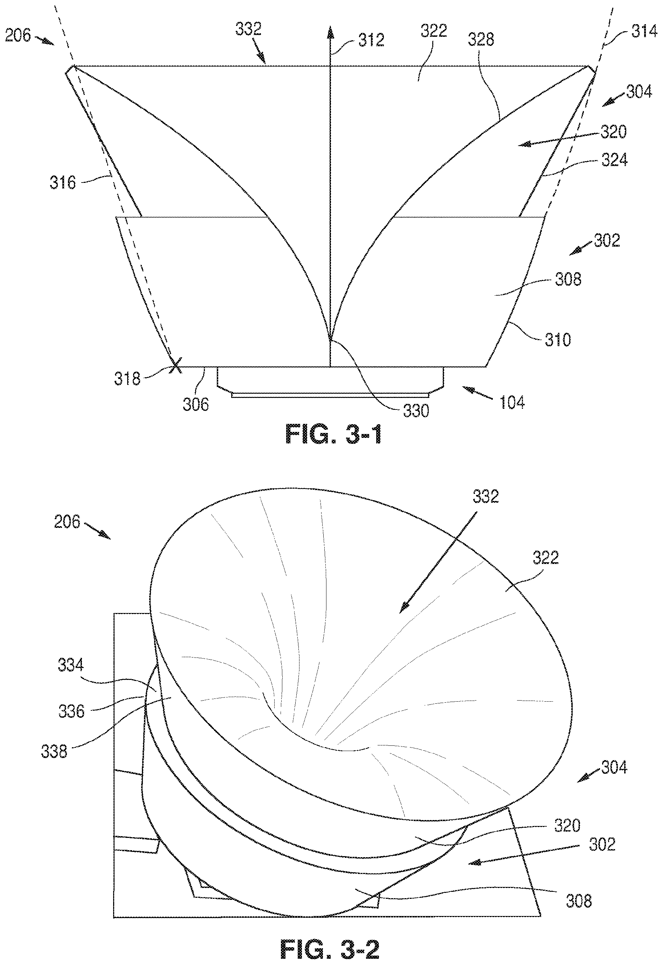

Figs. 3-1 and 3-2 respectively illustrate a cross-sectional side view and an isometric view of optic 206 in examples of the present disclosure. A truncated three-dimensional compound parabolic concentrator (CPC) 302 forms the bottom and lower portions of optic 206 while a three-dimensional tilted wedge 304 forms the upper and inner portions of optic 206.

Truncated CPC 302 includes a circular input face 306 and a lower exterior surface 308. Input face 306 makes optical contact with LED die 104. Input face 306 is sized to cover LED die 104. Input face 306 may have a diameter that matches or slightly exceeds the longest dimension of the emitting surface of LED die 104. The perimeter of circular input face 306 joins the bottom end of lower exterior surface 308.

Lower exterior surface 308 is defined by a parabolic segment 310 rotated about an axis of symmetry 312. This may also be described as two symmetrical parabolic segments rotated about axis of symmetry 312. Parabolic segment 310 is part of a parabola 314 (shown in phantom) having an optical axis 316 that tilts away from axis of symmetry 312 when travelling upward along optical axis 316. The bottom end of parabola 314 is cut off at the focus 318 of parabola 314, which is located at a far edge of input face 306. The upper end of parabola 314 is cut off at a truncated height less than the height of a full CPC.

Tilted wedge 304 is an optical component formed by rotating a tilted wedge-like cross-section that taper from a thicker lower end to a thinner top end about axis of symmetry 312. Tilted wedge 304 includes an upper exterior surface 320 above lower exterior surface 308 of truncated CPC 302, and an interior conical surface 322 surrounded by upper exterior surface 320 and lower exterior surface 308. Upper exterior surface 320 is defined by a segment 324 rotated about axis of symmetry 312. In accordance with the present invention as defined by the appended claims, segment 324 is straight but may be curved in other examples of the present disclosure, although not forming part of the present invention. Straight segment 324 tilts away from axis of symmetry 312 when travelling upward along straight segment 324. The top ends of upper exterior surface 320 and interior conical surface 322 join to define an output aperture 332.

Interior conical surface 322 is defined by a line 328 rotated about axis of symmetry 312. In accordance with the present invention, line 328 is a smooth curve but may be straight in other examples of the present disclosure, although not forming part of the present invention.

Smooth curve 328 may be may be a Bezier curve or another mathematical representation of a smooth curve. At least a majority of smooth curve 328 turns away from axis of symmetry 312 when travelling upward along smooth curve 328. A short top end portion of smooth curve 328 may turn toward axis of symmetry 312 when travelling upward along smooth curve 328. Interior conical surface 322 has a vertex 330 located on axis of symmetry 312 within lower exterior surface 308. Vertex 330 may be located on or slightly above input face 306.

An intermediate surface 334 bridges the gap between the larger upper end of lower exterior surface 308 and the smaller lower end of upper exterior surface 320. Intermediate surface 334 is an annulus having an outer circumference 336 joined to the upper end of the lower exterior surface 308, and an inner circumference 338 joined to the lower end of upper exterior surface 320.

In some examples of the present disclosure, optic 206 has a compact design comparable to hemispherical dome overmold 106 for LED die 104. This allows optic 206 to be used in many applications designed for hemispheric dome overmold 106.

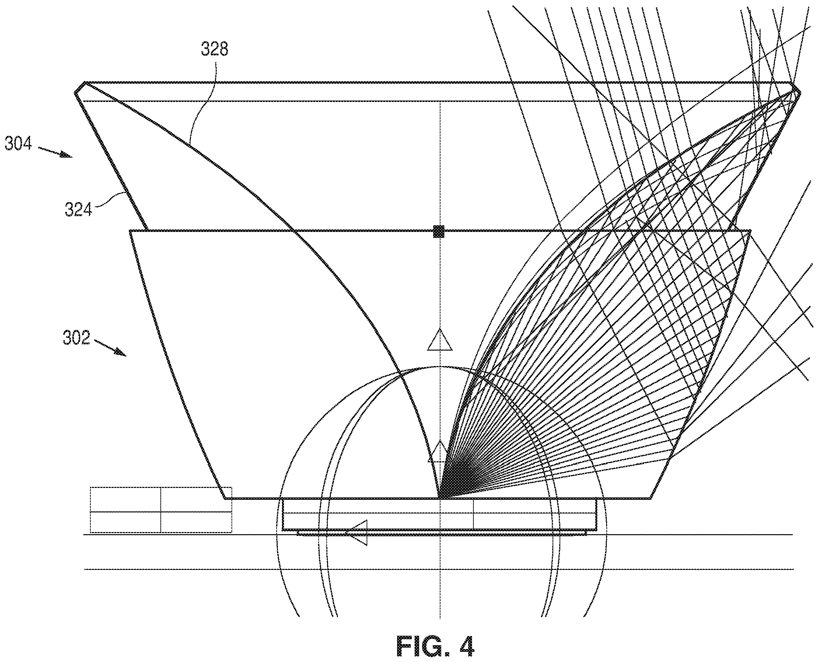

Fig. 4 illustrates ray tracing through optic 206 in examples of the present disclosure. Smooth curve 328 (labeled on the opposite side for clarity) of tilted wedge 304 reflects some of the rays away from axis of symmetry 312 towards straight segment 324 (labeled on the opposite side for clarity) of tilted wedge 304. Straight segment 324 subsequently redirects the rays along axis of symmetry 312. Some other rays are directly reflected by straight segment 324 along axis of symmetry, but then subsequently slightly diverged by smooth curve 324.

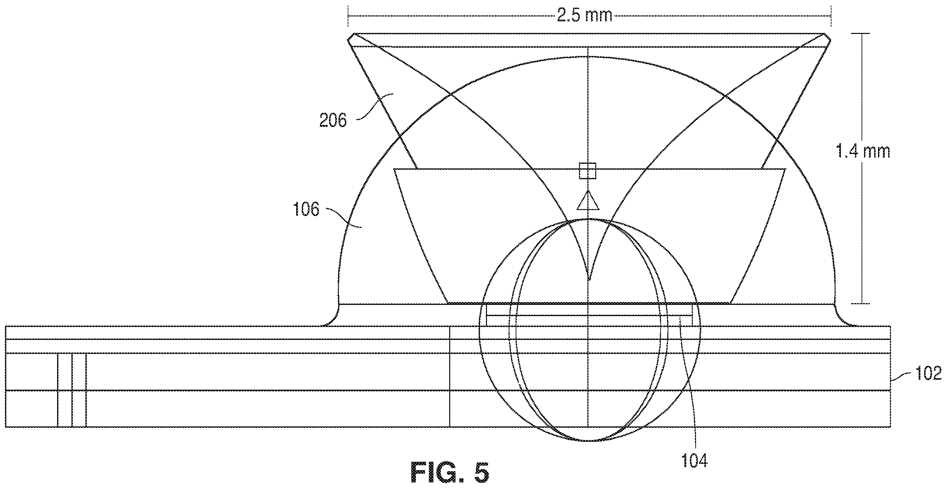

Fig. 5 illustrates that optic 206 has height and width that are substantially the same as hemispherical dome overmold 106 in some examples of the present disclosure. For a square LED die 104 having a side of 1 arbitrary unit (arb. unit) and a diagonal of 1.4 arb. unit, hemispherical dome overmold 106 typically has a height of 1.4 arb. unit and a width (diameter) of 2.5 arb. unit. For such a square LED die 104, optic 206 has a height of 1.4 arb. unit and a width (diameter) of 2.5 arb. unit.

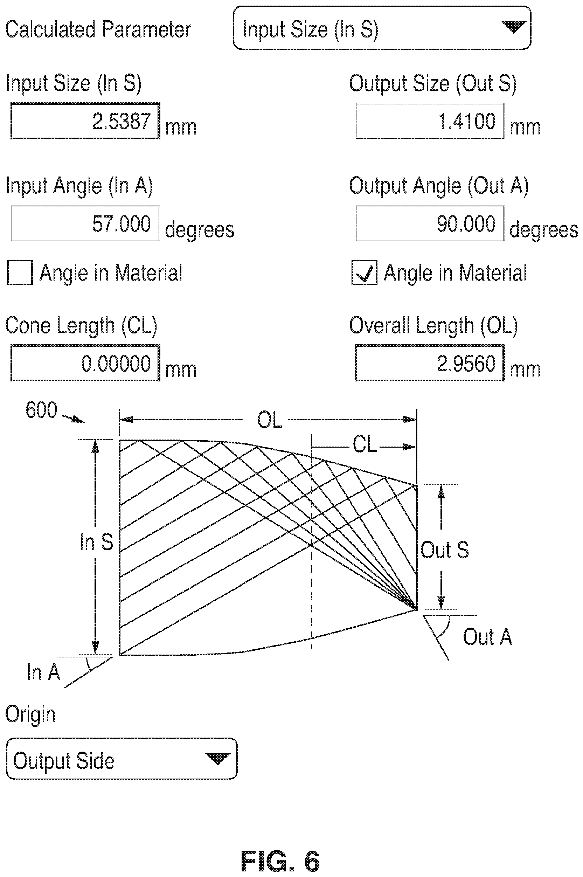

Fig. 6 illustrates the design of a full height CPC 600 cut to form truncated CPC 302 in examples of the present disclosure. Note the terminology in Fig. 6 is reversed as CPC 600 is typically used to collect light instead of emit light. Full height CPC 600 has an output size of 1.4100 arb. unit to fully cover LED die 104, an input size of 2.5387 arb. unit to about the height of hemispherical dome overmold 106, an output angle of 90 degrees to collect as much light as possible from LED die 104 that emits a Lambertian pattern from, and a cone length of 0 arb. unit. Based on these parameters, full height CPC 600 has an input angle (i.e., acceptance angle) of 57 degrees and an overall length of 2.9560 arb. unit. Note that the cone length is an optional straight line segment that may be added to the tilted parabola. The cone length value depends on the choice of output angle and is 0 for the above parameters. Full height CPC 600 is truncated at a truncated height less than the height of hemispheric dome overmold 106, such as a range from 0.4 to 1.2 arb. unit, to provide space for tilted wedge 304 atop truncated CPC 302. The truncated height may be selected based on ray tracing of optic 206 with various truncated heights.

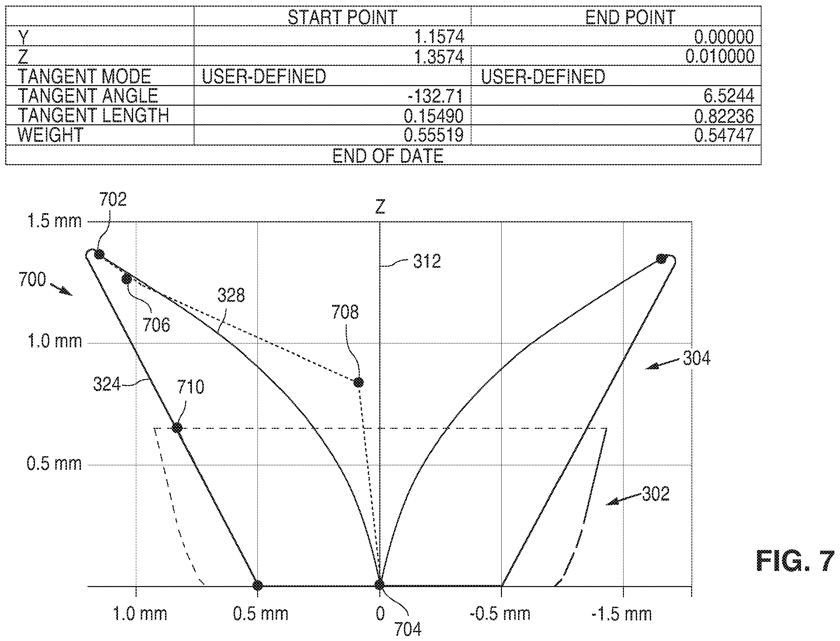

Fig. 7 illustrates the design of tilted wedge 700 superimposed on truncated CPC 302 (shown in phantom) to form optic 206 in examples of the present disclosure. The superimposed portions of tilted wedge 700 form tilted wedge 304. As described above, tilted wedge 304 is defined by rotating straight segment 324 and smooth curve 328 about axis of symmetry 312. When defined as a Bezier curve, smooth curve 328 may have a start point 702, an end point 704, and two control points 706, 708. Start point 702 is selected so the resulting titled wedge 304 has height and width similar to hemispheric dome overmold 106. For example, start point 702 is located at 1.3574 arb. unit in the Z-direction and 1.1574 arb. unit in the Y-direction, and end point 704 is located at the origin. Control point 706 causes a small top end portion smooth curve 328 to turn toward axis of symmetry 312 when travelling upward along smooth curve 328. Control point 706 has a tangent angle of - 132.71 degrees, a tangent length of 0.15490 arb. unit, and a weight of 0.55519. Control point 708 causes a majority of smooth curve 328 to turn away from axis of symmetry 312 when travelling upward along smooth curve 328. Control point 708 has a tangent angle of 6.5244 degrees, a tangent length of 0.82236 arb. unit, and a weight of 0.54747. Note the tangent modes for the start and end points describe how closely curve 328 approaches control points 706 and 708, which can be freely defined or automatically defined to smooth fit to the rest of curve.

Straight segment 324 has start point 702 (shared with smooth curve 328) and an end point 710. To avoid a sharp edge along the perimeter of output aperture 332 (Fig. 3), titled wedge 304 may be rounded about start point 702. As tilted wedge 304 is formed atop truncated CPC 302, end point 710 has the truncated height of truncated CPC 302. Straight segment 324 is part of a line that extends from start point 702 to an end point 712 at a side of LED die 104. In other words, the bottom end of tilted wedge 700 is located inside the top surface of LED die 104.

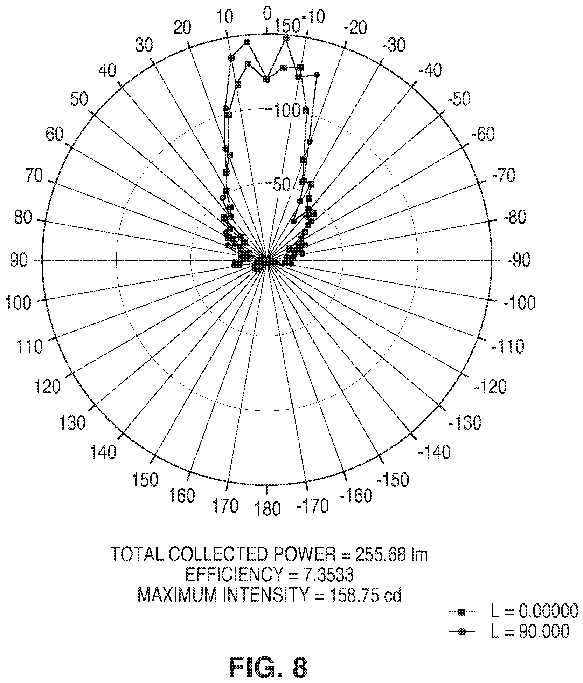

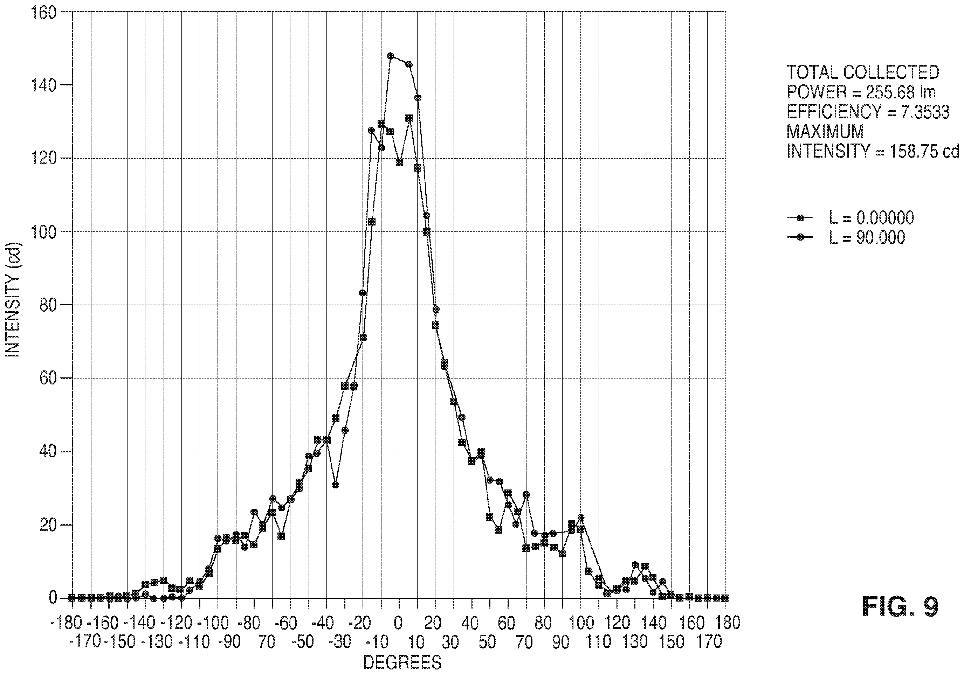

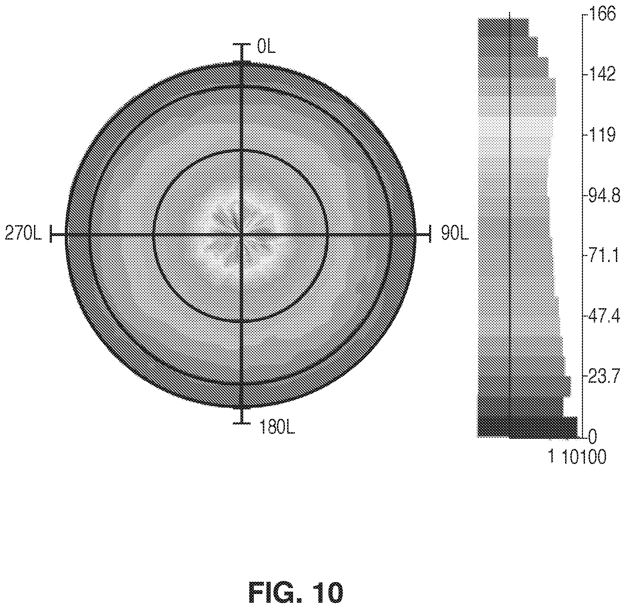

Figs. 8, 9, and 10 respectively illustrate the far field intensity distribution in intensity slices, the far field intensity distribution in cross-sections, and the forward intensity distribution of optic 206 in examples of the present disclosure. Optic 206 has a total collected power of 255.68 lumens, a collection efficiency of 7.3533, and a maximum intensity of 158.75 candelas. These numbers are substantially similar to hemispheric dome overmold 106, which has a total collected power of 263.07 lumens, a collection efficiency of 7.5658, and a maximum intensity of 72,267 candelas. Unlike hemispheric dome overmold 106, Fig. 8 shows optic 206 has a high degree of collimation. Unlike a full height CPC or a truncated CPC having the same height as hemispheric dome overmold 106, Figs. 9 and 10 show that optic 206 does not have a dark center. Thus, optic 206 has a compact design with superior performance than hemispheric dome overmold 106, a full height CPC, or a truncated CPC having the same height as hemispheric dome overmold 106. The scope of the present invention is defined by the following claims.

## Claims

1. An optic (206), comprising:
an input face (306);
a lower exterior surface (308) defined by a parabolic segment rotated about an axis of symmetry (312), the parabolic segment comprising a part of a parabola (314) with an optical axis (316) tilted away from the axis of symmetry (312) when travelling upward along the optical axis (316), wherein a bottom end of the lower exterior surface (308) joins a perimeter of the input face (306);
an upper exterior surface (320) above the lower exterior surface (308), the upper exterior surface (320) being defined by a straight line (324) rotated about the axis of symmetry (312), the straight line (324) being tilted away from the axis of symmetry (312) when travelling upward along the straight line (324);
an intermediate surface (334) comprising an annulus, the annulus having an outer circumference (336) that joins an upper end of the lower exterior surface (308) and an inner circumference (338) that joins a lower end of the upper exterior surface (320); and
an interior conical surface (322) surrounded by the lower and the upper exterior surfaces (308, 320), the interior conical surface being defined by a smooth curve (328) rotated about the axis of symmetry (312), at least a majority of the smooth curve (328) turning away from the axis of symmetry (312) when travelling upward along the smooth curve (328), wherein:
the interior conical surface (322) has a vertex (330) located at the axis of symmetry (312) and within the lower exterior surface (308); and
top ends of the interior conical surface (322) and the upper exterior surface (320) join to define an output aperture (332).

2. The optic of claim 1, wherein the lower exterior surface (308) comprises a truncated three-dimensional compound parabolic concentrator (302).

3. The optic of claim 2, wherein:
the input face (306) fully covers a light-emitting diode (LED) die (104) having a side of 1 arb. unit and a diagonal of 1.41 arb. unit; and
the truncated three-dimensional compound parabolic concentrator (302) has an input diameter of 2.54 arb. unit, an output diameter of 1.41 arb. unit, an input angle of 57 degrees, an output angle of 90 degrees, a full length of 2.96 arb. unit, and a truncated height of 0.4 to 1.2 arb. unit.

4. The optic of claim 1, wherein the upper exterior surface (320) and the interior conical surface (322) comprise a three-dimensional tilted wedge (304).

5. The optic of claim 4, wherein:
the input face (306) fully covers an LED die (104) having a side of 1 arb. unit and a diagonal of 1.41 arb. unit; and
the smooth curve (322) is a Bezier curve having an end point (704), a start point (702) located 1.35 arb. unit in a Z-direction and 1.16 arb. unit in a Y-direction from the start point, and two control points (706, 708).

6. A light-emitting diode (LED) package, comprising:
an LED die (104); and
the optic (206) according to claim 1, wherein the optic (206) is on the LED die (104).

7. The LED package of claim 6, wherein:
the lower exterior surface (308) comprises a truncated three-dimensional compound parabolic concentrator (302);
the input face (306) fully covers the LED die (104), wherein the LED die (104) has a side of 1 arb. unit and a diagonal of 1.41 arb. unit; and
the truncated three-dimensional compound parabolic concentrator (302) has an input diameter of 2.54 arb. unit, an output diameter of 1.41 arb. unit, an input angle of 57 degrees, an output angle of 90 degrees, a full length of 2.96 arb. unit, and a truncated height of 0.4 to 1.2 arb. unit.

8. The LED package of claim 7, wherein:
the input face (306) fully covers the LED die (104), wherein the LED die (104) has a side of 1 arb. unit and a
diagonal of 1.41 arb. unit; and
the smooth curve (322) is a Bezier curve having an end point (704), a start point (702) located 1.35 arb. unit in a Z-direction and 1.16 arb. unit in a Y-direction from the start point, and two control points (706, 708).

9. The LED package of claim 6, further comprising a heat sink (102), wherein the LED die (104) is mounted on the heat sink (102).

10. A method for making a light-emitting diode (LED) package, comprising:
providing an LED die (104); and
printing a primary optic (206) on the LED die (104), comprising:
forming bottom and lower portions of the primary optic (206) comprising a truncated three-dimensional compound parabolic concentrator (302) including:
an input face (306); and
a lower exterior surface (308) defined by a parabolic segment rotated about an axis of symmetry (312), the parabolic segment comprising a part of a parabola (314) with an optical axis (316) tilted away from the axis of symmetry (312) when travelling upward along the optical axis (316), wherein a bottom end of the lower exterior surface (308) joins a perimeter of the input face (306);
forming upper and inner portions of the primary optic comprising a three-dimensional tilted wedge (304) including:
an upper exterior surface (320) above the lower exterior surface (308), the upper exterior surface (320) being defined by a straight line (324) rotated about the axis of symmetry (314), the straight line (324) being tilted away from the axis of symmetry when travelling upward along the straight line;
an intermediate surface (334) comprising an annulus, the annulus having an outer circumference (336)
that joins an upper end of the lower
exterior surface (308) and an inner circumference (338) that joins a lower end of the upper exterior surface (320); and
an interior conical surface (322) surrounded by the lower and the upper exterior surfaces (308, 320), the interior conical surface (322) being defined by a smooth curve (328) rotated about the axis of symmetry, at least a majority of the smooth curve (328) turning away from the axis of symmetry (312) when travelling upward along the smooth curve (328),
wherein:
the interior conical surface (322) has a vertex (330) located at the axis of symmetry (312) and within the lower exterior surface (308), and top ends of the interior conical surface (322) and the upper exterior surface (320) join to define an output aperture (332).

11. The method of claim 10, wherein:
the input face (306) fully covers the LED die (104), wherein the LED die (104) has a side of 1 arb. unit and a diagonal of 1.41 arb. unit; and
the truncated three-dimensional compound parabolic concentrator (302) has an input diameter of 2.54 arb. unit, an output diameter of 1.41 arb. unit, an input angle of 57 degrees, an output angle of 90 degrees, a full length of 2.96 arb. unit, and a truncated height of 0.4 to 1.2 arb. unit.

12. The method of claim 10, wherein:
the input face (306) fully covers the LED die (104), wherein the LED die (104) has a side of 1 arb. unit and a diagonal of 1.41 arb. unit; and
the smooth curve (322) is a Bezier curve having an end point (704), a start point (702) located 1.35 arb. unit in a Z-direction and 1.16 arb. unit in a Y-direction from the start point, and two control points (706, 708).

13. The method of claim 10, further comprising mounting the LED die (104) on a heatsink (102).

## Patentansprüche

1. Optik (206), umfassend:
eine Eingangsfläche (306),
eine untere Außenoberfläche (308), die durch ein Parabolsegment definiert ist, das um eine Symmetrieachse (312) gedreht ist, wobei das Parabolsegment einen Teil einer Parabel (314) mit einer optischen Achse (316) umfasst, die bei Bewegung nach oben entlang der optischen Achse (316) von der Symmetrieachse (312) weg geneigt ist, wobei ein unteres Ende der unteren Außenoberfläche (308) an eine Umfassung der Eingangsfläche (306) anschließt,
eine obere Außenoberfläche (320) oberhalb der unteren Außenoberfläche (308), wobei die obere Außenoberfläche (320) durch eine gerade Linie (324) definiert ist, die um die Symmetrieachse (312) gedreht ist, wobei die gerade Linie (324) bei Bewegung nach oben entlang der geraden Linie (324) von der Symmetrieachse (312) weg geneigt ist,
eine Zwischenoberfläche (334), die einen Ring umfasst, wobei der Ring einen Außenumfang (336) aufweist, der an ein oberes Ende der unteren Außenoberfläche (308) anschließt, und einen Innenumfang (338), der an ein unteres Ende der oberen Außenoberfläche (320) anschließt, und
eine konische Innenoberfläche (322), die von der unteren und der oberen Außenoberfläche (308, 320) umgeben ist, wobei die konische Innenoberfläche durch eine gleichmäßige Kurve (328) definiert ist, die um die Symmetrieachse (312) gedreht ist, wobei sich zumindest ein Großteil der gleichmäßigen Kurve (328) bei Bewegung nach oben entlang der gleichmäßigen Kurve (328) von der Symmetrieachse (312) abwendet, wobei:
die konische Innenoberfläche (322) einen Scheitel (330) aufweist, der an der Symmetrieachse (312) und innerhalb der unteren Außenoberfläche (308) liegt, und
sich obere Enden der konischen Innenoberfläche (322) und der oberen Außenoberfläche (320) aneinander anschließen, um eine Ausgangsapertur (332) zu definieren.

2. Optik nach Anspruch 1, wobei die untere Außenoberfläche (308) einen aus abgeschnittenen dreidimensionalen Parabelformen zusammengesetzten Konzentrator (302) umfasst.

3. Optik nach Anspruch 2, wobei:
die Eingangsfläche (306) einen Leuchtdioden- (LED-)Nacktchip (104) vollständig bedeckt, der eine Seite von 1 willkürlichen Einheit und eine Diagonale von 1,41 willkürlichen Einheiten aufweist, und
der aus abgeschnittenen dreidimensionalen Parabelformen zusammengesetzten Konzentrator (302) einen Eingangsdurchmesser von 2,54 willkürlichen Einheiten, einen Ausgangsdurchmesser von 1,41 willkürlichen Einheiten, einen Eingangswinkel von 57 Grad, einen Ausgangswinkel von 90 Grad, eine volle Länge von 2,96 willkürlichen Einheiten und eine abgeschnittene Höhe von 0,4 bis 1,2 willkürlichen Einheiten aufweist.

4. Optik nach Anspruch 1, wobei die obere Außenoberfläche (320) und die konische Innenoberfläche (322) einen dreidimensionalen geneigten Keil (304) umfassen.

5. Optik nach Anspruch 4, wobei:
die Eingangsfläche (306) einen LED-Nacktchip (104) vollständig bedeckt, der eine Seite von 1 willkürlichen Einheit und eine Diagonale von 1,41 willkürlichen Einheiten aufweist, und
die gleichmäßige Kurve (322) eine Bezierkurve ist, die einen Endpunkt (704), einen Startpunkt (702), der 1,35 willkürliche Einheiten in einer Z-Richtung und 1,16 willkürliche Einheiten in einer Y-Richtung von dem Startpunkt aus liegt, und zwei Steuerpunkte (706, 708) aufweist.

6. Leuchtdioden- (LED-)Gehäuse, umfassend:
einen LED-Nacktchip (104) und
die Optik (206) nach Anspruch 1, wobei sich die Optik (206) auf dem LED-Nacktchip (104) befindet.

7. LED-Gehäuse nach Anspruch 6, wobei:
die untere Außenoberfläche (308) einen aus abgeschnittenen dreidimensionalen Parabelformen zusammengesetzten Konzentrator (302) umfasst,
die Eingangsfläche (306) den LED-Nacktchip (104) vollständig bedeckt, wobei der LED-Nacktchip (104) eine Seite von 1 willkürlichen Einheit und eine Diagonale von 1,41 willkürlichen Einheiten aufweist, und
der aus abgeschnittenen dreidimensionalen Parabelformen zusammengesetzten Konzentrator (302) einen Eingangsdurchmesser von 2,54 willkürlichen Einheiten, einen Ausgangsdurchmesser von 1,41 willkürlichen Einheiten, einen Eingangswinkel von 57 Grad, einen Ausgangswinkel von 90 Grad, eine volle Länge von 2,96 willkürlichen Einheiten und eine abgeschnittene Höhe von 0,4 bis 1,2 willkürlichen Einheiten aufweist.

8. LED-Gehäuse nach Anspruch 7, wobei:
die Eingangsfläche (306) den LED-Nacktchip (104) vollständig bedeckt, wobei der LED-Nacktchip (104) eine Seite von 1 willkürlichen Einheit und eine Diagonale von 1,41 willkürlichen Einheiten aufweist, und
die gleichmäßige Kurve (322) eine Bezierkurve ist, die einen Endpunkt (704), einen Startpunkt (702), der 1,35 willkürliche Einheiten in einer Z-Richtung und 1,16 willkürliche Einheiten in einer Y-Richtung von dem Startpunkt aus liegt, und zwei Steuerpunkte (706, 708) aufweist.

9. LED-Gehäuse nach Anspruch 6, ferner eine Wärmesenke (102) umfassend, wobei der LED-Nacktchip (104) auf die Wärmesenke (102) montiert ist.

10. Verfahren zum Herstellen eines Leuchtdioden- (LED-)Gehäuses, umfassend:
Bereitstellen eines LED-Nacktchips (104) und
Drucken einer primären Optik (206) auf den LED-Nacktchip (104), umfassend:
Bilden unterer und oberer Abschnitte der primären Optik (206), umfassend einen aus abgeschnittenen dreidimensionalen Parabelformen zusammengesetzten Konzentrator (302), Folgendes beinhaltend:
eine Eingangsfläche (306), und
eine untere Außenoberfläche (308), die durch ein Parabolsegment definiert ist, das um eine Symmetrieachse (312) gedreht ist, wobei das Parabolsegment einen Teil einer Parabel (314) mit einer optischen Achse (316) umfasst, die bei Bewegung nach oben entlang der optischen Achse (316) von der Symmetrieachse (312) weg geneigt ist, wobei ein unteres Ende der unteren Außenoberfläche (308) an eine Umfassung der Eingangsfläche (306) anschließt,
Bilden oberer und innerer Abschnitte der primären Optik, die einen dreidimensionalen geneigten Keil umfassen (304), Folgendes beinhaltend:
eine obere Außenoberfläche (320) oberhalb der unteren Außenoberfläche (308), wobei die obere Außenoberfläche (320) durch eine gerade Linie (324) definiert ist, die um die Symmetrieachse (314) gedreht ist, wobei die gerade Linie (324) bei Bewegung nach oben entlang der geraden Linie von der Symmetrieachse weg geneigt ist,
eine Zwischenoberfläche (334), die einen Ring umfasst, wobei der Ring einen Außenumfang (336) aufweist, der an ein oberes Ende der unteren Außenoberfläche (308) anschließt, und einen Innenumfang (338), der an ein unteres Ende der oberen Außenoberfläche (320) anschließt, und
eine konische Innenoberfläche (322), die von der unteren und der oberen Außenoberfläche (308, 320) umgeben ist, wobei die konische Innenoberfläche (322) durch eine gleichmäßige Kurve (328) definiert ist, die um die Symmetrieachse gedreht ist, wobei sich zumindest ein Großteil der gleichmäßigen Kurve (328) bei Bewegung nach oben entlang der gleichmäßigen Kurve (328) von der Symmetrieachse (312) abwendet, wobei:
die konische Innenoberfläche (322) einen Scheitel (330) aufweist, der an der Symmetrieachse (312) und innerhalb der unteren Außenoberfläche (308) liegt, und sich obere Enden der konischen Innenoberfläche (322) und der oberen Außenoberfläche (320) aneinander anschließen, um eine Ausgangsapertur (332) zu definieren.

11. Verfahren nach Anspruch 10, wobei:
die Eingangsfläche (306) den LED-Nacktchip (104) vollständig bedeckt, wobei der LED-Nacktchip (104) eine Seite von 1 willkürlichen Einheit und eine Diagonale von 1,41 willkürlichen Einheiten aufweist, und
der aus abgeschnittenen dreidimensionalen Parabelformen zusammengesetzte Konzentrator (302) einen Eingangsdurchmesser von 2,54 willkürlichen Einheiten, einen Ausgangsdurchmesser von 1,41 willkürlichen Einheiten, einen Eingangswinkel von 57 Grad, einen Ausgangswinkel von 90 Grad, eine volle Länge von 2,96 willkürlichen Einheiten und eine abgeschnittene Höhe von 0,4 bis 1,2 willkürlichen Einheiten aufweist.

12. Verfahren nach Anspruch 10, wobei:
die Eingangsfläche (306) den LED-Nacktchip (104) vollständig bedeckt, wobei der LED-Nacktchip (104) eine Seite von 1 willkürlichen Einheit und eine Diagonale von 1,41 willkürlichen Einheiten aufweist, und
die gleichmäßige Kurve (322) eine Bezierkurve ist, die einen Endpunkt (704), einen Startpunkt (702), der 1,35 willkürliche Einheiten in einer Z-Richtung und 1,16 willkürliche Einheiten in einer Y-Richtung von dem Startpunkt aus liegt, und zwei Steuerpunkte (706, 708) aufweist.

13. Verfahren nach Anspruch 10, ferner das Montieren des LED-Nacktchips (104) auf einer Wärmesenke (102) umfassend.

## Revendications

1. Optique (206), comprenant :
une face d'entrée (306) ;
ne surface extérieure inférieure (308) définie par un segment parabolique en rotation autour d'un axe de symétrie (312), le segment parabolique comprenant une partie d'une parabole (314) avec un axe optique (316) incliné à l'écart de l'axe de symétrie (312) en remontant le long de l'axe optique (316), dans laquelle une extrémité de fond de la surface extérieure inférieure (308) rejoint un périmètre de la face d'entrée (306) ;
une surface extérieure supérieure (320) au-dessus de la surface extérieure inférieure (308), la surface extérieure supérieure (320) étant définie par une ligne droite (324) en rotation autour de l'axe de symétrie (312), la ligne droite (324) étant inclinée à l'écart de l'axe de symétrie (312) en remontant le long de la ligne droite (324) ;
une surface intermédiaire (334) comprenant un anneau, l'anneau ayant une circonférence externe (336) qui rejoint une extrémité supérieure de la surface extérieure inférieure (308) et une circonférence interne (338) qui rejoint une extrémité inférieure de la surface extérieure supérieure (320) ; et
une surface conique intérieure (322) entourée par les surfaces extérieures inférieure et supérieure (308, 320), la surface conique intérieure étant définie par une courbe lisse (328) en rotation autour de l'axe de symétrie (312), au moins une majeure partie de la courbe lisse (328) tournant à l'écart de l'axe de symétrie (312) en remontant le long de la courbe lisse (328), dans laquelle :
la surface conique intérieure (322) a un sommet (330) situé au niveau de l'axe de symétrie (312) et à l'intérieur de la surface extérieure inférieure (308) ; et
les extrémités supérieures de la surface conique intérieure (322) et de la surface extérieure supérieure (320) se rejoignent pour définir une ouverture de sortie (332).

2. Optique selon la revendication 1, dans laquelle la surface extérieure inférieure (308) comprend un concentrateur parabolique composé tridimensionnel tronqué (302).

3. Optique selon la revendication 2, dans laquelle :
la face d'entrée (306) couvre complètement une puce de diode électroluminescente (DEL) (104) ayant un côté de 1 unité arb. et une diagonale de 1,41 unité arb. ; et
le concentrateur parabolique composé tridimensionnel tronqué (302) a un diamètre d'entrée de 2,54 unité arb., un diamètre de sortie de 1,41 unité arb., un angle d'entrée de 57 degrés, un angle de sortie de 90 degrés, une longueur totale de 2,96 unités arb. et une hauteur tronquée de 0,4 à 1,2 unité arb..

4. Optique selon la revendication 1, dans laquelle la surface extérieure supérieure (320) et la surface conique intérieure (322) comprennent un coin incliné tridimensionnel (304).

5. Optique selon la revendication 4, dans laquelle :
la face d'entrée (306) couvre complètement une puce DEL (104) ayant un côté de 1 unité arb. et une diagonale de 1,41 unité arb. ; et
la courbe lisse (322) est une courbe de Bézier ayant un point d'extrémité (704), un point de départ (702) situé à 1,35 unité arb. dans une direction Z et 1,16 unité arb. dans une direction Y à partir du point de départ, et deux points de contrôle (706, 708).

6. Boîtier de diode électroluminescente (DEL), comprenant :
une puce DEL (104) ; et
l'optique (206) selon la revendication 1, dans lequel l'optique (206) est sur la puce DEL (104).

7. Boîtier de DEL selon la revendication 6, dans lequel :
la surface extérieure inférieure (308) comprend un concentrateur parabolique composé tridimensionnel tronqué (302) ;
la face d'entrée (306) couvre complètement la puce DEL (104), dans lequel la puce DEL (104) a un côté de 1 unité arb. et une diagonale de 1,41 unité arb. ; et
le concentrateur parabolique composé tridimensionnel tronqué (302) a un diamètre d'entrée de 2,54 unités arb., un diamètre de sortie de 1,41 unité arb., un angle d'entrée de 57 degrés, un angle de sortie de 90 degrés, une longueur totale de 2,96 unités arb. et une hauteur tronquée de 0,4 à 1,2 unité arb..

8. Boîtier de DEL selon la revendication 7, dans lequel :
la face d'entrée (306) couvre complètement la puce DEL (104), dans lequel la puce DEL (104) a un côté de 1 unité arb. et une diagonale de 1,41 unité arb. ; et
la courbe lisse (322) est une courbe de Bézier ayant un point d'extrémité (704), un point de départ (702) situé à 1,35 unité arb. dans une direction Z et 1,16 unité arb. dans une direction Y du point de départ, et deux points de contrôle (706, 708).

9. Boîtier de DEL selon la revendication 6, comprenant en outre un dissipateur thermique (102), dans lequel la puce DEL (104) est montée sur le dissipateur thermique (102).

10. Procédé de fabrication d'un boîtier de diode électroluminescente (DEL), comprenant :
la fourniture d'une puce DEL (104) ; et
l'impression d'une optique primaire (206) sur la puce DEL (104), comprenant :
la formation de parties de fond et inférieure de l'optique primaire (206) comprenant un concentrateur parabolique composé tridimensionnel tronqué (302) incluant :
une face d'entrée (306) ; et
une surface extérieure inférieure (308) définie par un segment parabolique en rotation autour d'un axe de symétrie (312), le segment parabolique comprenant une partie d'une parabole (314) avec un axe optique (316) incliné à l'écart de l'axe de symétrie (312) en remontant le long de l'axe optique (316), dans lequel une extrémité de fond de la surface extérieure inférieure (308) rejoint un périmètre de la face d'entrée (306) ;
la formation de parties supérieures et internes de l'optique primaire comprenant un coin incliné tridimensionnel (304) incluant :
une surface extérieure supérieure (320) au-dessus de la surface extérieure inférieure (308), la surface extérieure supérieure (320) étant définie par une ligne droite (324) en rotation autour de l'axe de symétrie (314), la ligne droite (324) étant inclinée à l'écart de l'axe de symétrie en remontant le long de la ligne droite ;
une surface intermédiaire (334) comprenant un anneau, l'anneau ayant une circonférence externe (336) qui rejoint une extrémité supérieure de la surface extérieure inférieure (308) et une circonférence interne (338) qui rejoint une extrémité inférieure de la surface extérieure supérieure (320) ; et
une surface conique intérieure (322) entourée par les surfaces extérieures inférieure et supérieure (308, 320), la surface conique intérieure (322) étant définie par une courbe lisse (328) en rotation autour de l'axe de symétrie, au moins une majeure partie de la courbe lisse (328) tournant à l'écart de l'axe de symétrie (312) en remontant le long de la courbe lisse (328), dans lequel :
la surface conique intérieure (322) a un sommet (330) situé au niveau de l'axe de symétrie (312) et à l'intérieur de la surface extérieure inférieure (308) ; et les extrémités supérieures de la surface conique intérieure (322) et de la surface extérieure supérieure (320) se rejoignent pour définir une ouverture de sortie (332).

11. Procédé selon la revendication 10, dans lequel :
la face d'entrée (306) couvre complètement la puce DEL (104), dans lequel la puce DEL (104) a un côté de 1 unité arb. et une diagonale de 1,41 unité arb. ; et
le concentrateur parabolique composé tridimensionnel tronqué (302) a un diamètre d'entrée de 2,54 unités arb., un diamètre de sortie de 1,41 unité arb., un angle d'entrée de 57 degrés, un angle de sortie de 90 degrés, une longueur totale de 2,96 unités arb. et une hauteur tronquée de 0,4 à 1,2 unité arb..

12. Procédé selon la revendication 10, dans lequel :
la face d'entrée (306) couvre complètement la puce DEL (104), dans lequel la puce DEL (104) a un côté de 1 unité arb. et une diagonale de 1,41 unité arb. ; et
la courbe lisse (322) est une courbe de Bézier ayant un point d'extrémité (704), un point de départ (702) situé à 1,35 unité arb. dans une direction Z et 1,16 unité arb. dans une direction Y à partir du point de départ, et deux points de contrôle (706, 708).

13. Procédé selon la revendication 10, comprenant en outre le montage de la puce DEL (104) sur un dissipateur thermique (102).
